# EUROPEAN PATENT APPLICATION

(11) **EP 4 618 062 A1**
(43) Date of publication of application: **17.09.2025**
(21) Application number: 23889066.9
(22) Date of filing: 03.11.2023
(51) Int. Cl.: G09F 9/30, G06F 1/16, H04M 1/02, H10K 77/10, H10K 50/84, H10K 102/00

(54) **DISPLAY DEVICE**

(30) Priority: 08.11.2022 KR 20220147792
(71) Applicant: Samsung Display Co., Ltd., Yongin-si, Gyeonggi-do 17113 (KR)
(72) Inventor: HA, Seung Hwa, Yongin-si Gyeonggi-do 17113 (KR)
(74) Representative: Dr. Weitzel & Partner
(86) International application number: PCT/KR2023/017548
(87) International publication number: WO 2024/101805

(57) **Abstract**

A display device includes a display module including a first area and a second area adjacent to the first area, wherein at least a portion of the second area is curved, a flat support disposed under the display module and overlapping the first area, and a plurality of segments disposed under the display module, overlapping the second area, and each having a structure including a plurality of laminated plates.

## Description

### [Technical Field]

The present invention generally relates to a display device. More particularly, the present invention relates to a curved display device including laminated plates.

### [Background Art]

With the development of information technology, the importance of a display device, which is a connection medium between a user and information, has been highlighted. For example, the use of a display device such as a liquid crystal display ("LCD") device, an organic light emitting diode ("OLED") display device, a plasma display device ("PDP"), a quantum dot display device, and/or the like is increasing.

Recently, a flexible display device that can be bent is in demand. For example, the flexible display device such as a foldable display device, a slidable display device, or the like is being used. Such display devices may be capable of being flexed, folded, slide, etc., to a noticeable degree without cracking or otherwise sustaining damage.

### [Detailed Explanation of the Invention]

### [Technical Purpose]

An object of the present invention is to provide a display device with improved reliability.

However, the object of the present invention is not limited to this object, and may be expanded in various ways without departing from the spirit and scope of the present invention.

### [Technical Solution]

A display device includes a display module including a first area and a second area adjacent to the first area, a flat support disposed under the display module and overlapping the first area, and a plurality of segments disposed under the display module, overlapping the second area, and each having a structure including a plurality of laminated plates. At least a portion of the second area is curved with a constant curvature.

At least two of the plates may include materials different from each other.

The plates may include a same material as each other.

Each of the plates may include stainless steel (SUS), fiber reinforced plastic (FRP), and/or magnesium (Mg).

The plates may have a same shape as each other.

Each of the plates may include a first portion facing the display module, a second portion contacting the first portion and having a rectangular cross-sectional shape with one side open (e.g., a rectangular bracket shape), and two third portions respectively contacting both ends of the second portion.

Both ends of the first portion may protrude to a greater extent than both ends of each of the third portions.

At least one corner portion disposed inside the second portion may have a cross-sectional shape including a straight line or a curved line extending in an oblique direction.

Each of the segments may include a contact structure coupled to both ends of the first portion and to each of the third portions.

The contact structure may be integrally formed with the segment.

The contact structure may have a polygonal cross-sectional shape.

The contact structure may have a quadrilateral cross-sectional shape or a triangular cross-sectional shape.

Each of the segments may include a plurality of pins inserted into the first portion and spaced apart from each other at regular intervals.

The display device may further include a support plate disposed under the display module and including a first plate and overlapping the first area and a second plate overlapping the second area and extending from the first plate.

A plurality of openings spaced apart from each other at regular intervals may be disposed in the second plate.

Each of the segments may directly contact the second plate and might not overlap the openings.

A display device includes a display module including a first area and a second area adjacent to the first area. At least a portion of the second area is curved with a constant curvature and a plurality of segments disposed under the display module. The segments overlap the second area, are spaced apart from each other in a first direction, each extend in a second direction crossing the first direction, and each has a structure including a plurality of laminated plates.

At least two of the plates may include materials different from each other.

The plates may include a same material as each other.

Each of the plates may include stainless steel, fiber reinforced plastic, and/or magnesium.

Each of the plates may include a first portion facing the display module, a second portion contacting the first portion and having a rectangular cross-sectional shape with one side open (e.g., a rectangular bracket shape), and two third portions respectively contacting both ends of the second portion.

Both ends of the first portion may protrude to a greater extent than both ends of each of the third portions.

At least one corner portion disposed inside the second portion may have a cross-sectional shape including a straight line or a curved line extending in an oblique direction.

Each of the segments may include a contact structure coupled to both ends of the first portion and to each of the third portions.

The contact structure may be integrally formed with the segments.

The contact structure may have a quadrilateral cross-sectional shape or a triangular cross-sectional shape.

Each of the segments may include a plurality of pins inserted into the first portion and spaced apart from each other at regular intervals.

### [Advantageous Effects]

According to the display device of the embodiments of the present invention may include a display module including a first area and a second area adjacent to the first area and a plurality of segments disposed under the display module, overlapping the second area, and each having a structure including a plurality of plates are laminated. At least a portion of the second area may be curved to have a constant curvature. Accordingly, rigidity of each of the segments in a specific direction (e.g., a direction in which the segments extend) may be improved.

In addition, at least two of the plurality of plates may include materials different from each other. Accordingly, weight reduction of the segments may be realized.

However, the effects of the present invention are not limited to the above effects, and may be expanded in various ways without departing from the spirit and scope of the present invention.

### [Brief Description of the Drawings]

FIG. 1 is a plan view illustrating a display device according to an embodiment of the present invention.
FIG. 2 is a cross-sectional view taken along line I-I' of FIG. 1.
FIG. 3 is a cross-sectional view taken along line II-II' of FIG. 1.
FIG. 4 is a cross-sectional view illustrating the display device of FIG. 3 in an unfolded state.
FIG. 5 is an enlarged cross-sectional view of a portion of the display panel of FIG. 2.
FIG. 6 is a plan view illustrating a flat bar and the segments of FIG. 2.
FIG. 7 is an enlarged plan view of an example of area A of FIG. 6.
FIGS. 8 and 9 are enlarged plan views of other examples of area A of FIG. 6.
FIG. 10 is a cross-sectional view illustrating an example of a cross-section of the segments of FIGS. 6 and 7 taken along line III-III'.
FIGS. 11, 12, 13, and 14 are cross-sectional views illustrating other examples of a cross-section of the segments of FIGS. 6 and 7 taken along line III-III'.
FIG. 15 is a plan view illustrating a display device according to an embodiment of the present invention.
FIG. 16 is a cross-sectional view taken along line IV-IV' of FIG. 15.
FIG. 17 is a plan view illustrating a display device according to an embodiment of the present invention.
FIG. 18 is a cross-sectional view taken along line V-V' of FIG. 15.

### [Best Mode]

### [Mode for Invention]

Hereinafter, a display device according to embodiments of the present invention will be explained in detail with reference to the accompanying drawings. The same reference numerals are used for the same components in the drawings, and to the extent that an element is not described in detail, it may be understood that the element is at least similar to corresponding elements that have been described elsewhere within the instant specification.

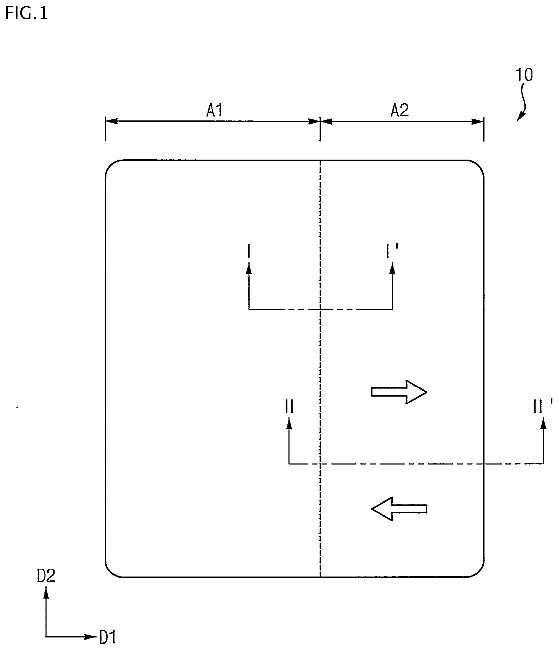

FIG. 1 is a plan view illustrating a display device according to an embodiment of the present invention.

Referring to FIG. 1, a display device 10, according to an embodiment, may include a first area A1 and a second area A2. The second area A2 may be disposed adjacent to the first area A1. For example, the second area A2 may be adjacent to the first area A1 in a first direction D1.

Each of the first area A1 and the second area A2 may be a display area for displaying an image. However, the configuration of the present invention is not necessarily limited thereto, and each of the first area A1 and the second area A2 may partially display an image.

The display device 10 may be a sliding display device capable of adjusting a size of an area for displaying an image through sliding. For example, when the display device 10 is unfolded, the display area may be expanded, and when the display device 10 is rolled, the display area may be reduced.

The first area A1 may be an area exposed to the outside of the display device 10 and may have a flat shape. The second area A2 may be flexible, and may be exposed to the outside of the display device 10 or accommodated inside the display device 10 as the display device 10 slides. The second area A2 may have a flat shape when exposed to the outside, and may have a curved shape when accommodated inside.

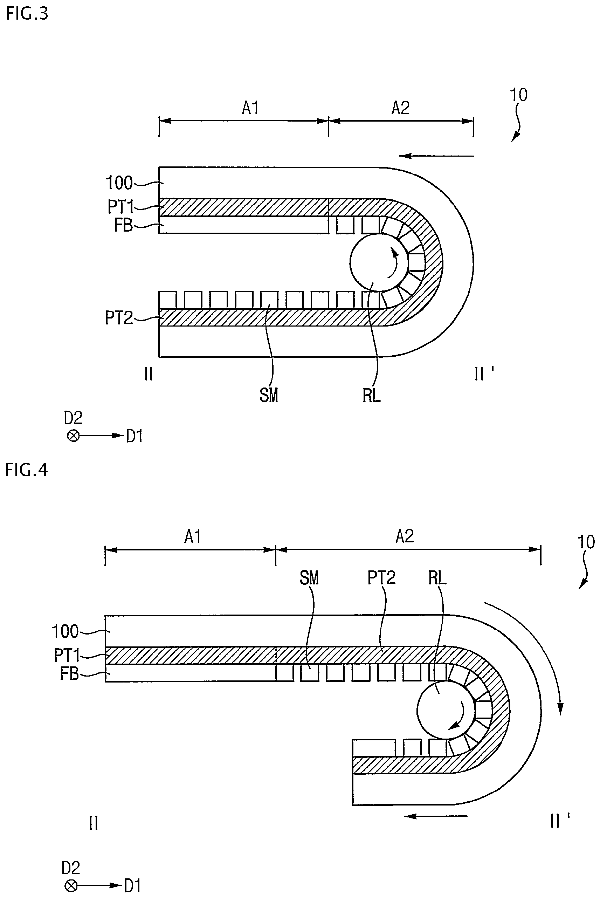

When the display device 10 is slid, the area of the second area A2 may change. For example, as shown in FIG. 4, when the display device 10 is slid and unfolded, the area of the second area A2 may increase. As shown in FIG. 3, when the display device 10 is slid and rolled, the area of the second area A2 may decrease.

Here, in a plan view, the first direction D1 may be parallel to a first side of the display device 10, and a second direction D2 may be parallel to a second side of the display device 10. The second direction D2 may be perpendicular to the first direction D1. For example, in the plan view, the first direction D1 may be a horizontal direction of the display device 10, and the second direction D2 may be a vertical direction of the display device 10.

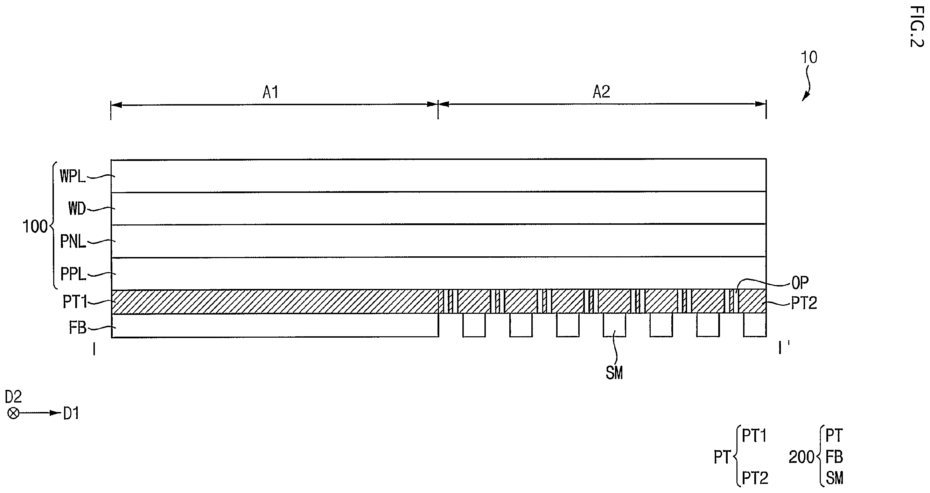

FIG. 2 is a cross-sectional view taken along line I-I' of FIG. 1.

Referring to FIGS. 1 and 2, the display device 10 according to an embodiment of the present invention may include a display module 100 and a lower structure 200. Here, the display module 100 includes a panel protection layer PPL, a display panel PNL, a window member WD, and a window protection layer WPL. The lower structure 200 may include a support plate PT, a flat bar FB, and a plurality of segments SM.

As described above, the display device 10 may include the first area A1 and the second area A2. As the display device 10 includes the first area A1 and the second area A2, components (e.g., the display module 100, the lower structure 200, and/or the like) included in the display device 10 may also include the first area A1 and the second area A2.

A first portion of the display module 100 overlapping the first area A1 may be exposed to the outside and may have a flat shape. A second portion of the display module 100 overlapping the second area A2 may be flexible. The second portion may extend in the first direction D1 from the first portion. The second portion may be exposed to the outside or accommodated inside as the display device 10 slides. The second portion may have a flat shape when exposed to the outside, and may have a curved shape when accommodated inside.

The display panel PNL may display an image. The display panel PNL may include a plurality of sub-pixels emitting light. For example, the display panel PNL may be an organic light emitting diode display panel, an inorganic light emitting display panel, a quantum dot display panel, a micro LED display panel, a nano LED display panel, a plasma display panel, a field emission display panel, a cathode ray display panel, a liquid crystal display panel, or an electrophoretic display panel.

The panel protection layer PPL may be disposed under the display panel PNL. The panel protection layer PPL may reduce stress applied to the display panel PNL when the display panel PNL is folded or bent. In addition, the panel protection layer PPL may prevent impurities and moisture from penetrating into the display panel PNL and may absorb external impact.

The panel protection layer PPL may include a plastic film. Examples of the plastic film that can be used for the panel protection layer PPL may include polyimide (PI), polycarbonate (PC), polypropylene (PP), polyethylene terephthalate (PET), polyethersulfone (PES), polymethyl methacrylate (PMMA), triacetyl cellulose (TAC), cyclo olefin polymer (COP), and/or the like. These may be used alone or in combination with each other.

The window member WD may be disposed on the display panel PNL. The window member WD may protect the display panel PNL from external impact. The window member WD may include a transparent material. For example, the window member WD may include glass or plastic.

The window protection layer WPL may be disposed on the window member WD. The window protection layer WPL may prevent the window member WD from being damaged by an external impact. The window protection layer WPL may include a transparent polymer film. Examples of the transparent polymer film that can be used for the window protection layer WPL may include polyethylene terephthalate (PET), polyethylene naphthalate (PEN), polyethersulfone (PES), polyimide (PI), polyarylate (PAR), polymethyl methacrylate (PMMA), cyclo olefin polymer (COP), polycarbonate (PC), and/or the like. These may be used alone or in combination with each other.

Each of the display panel PNL, the panel protection layer PPL, the window member WD, and the window protection layer WPL may be flexible. Accordingly, each of the display panel PNL, the panel protection layer PPL, the window member WD, and the window protection layer WPL may be repeatedly bent or unfolded without being damaged.

The support plate PT may be disposed under the display module 100. For example, the support plate PT may include metal. The support plate PT may include a first plate PT1 and a second plate PT2. The first plate PT1 may overlap the first area A1 and the second plate PT2 may overlap the second area A2.

The first plate PT1 may have relatively high rigidity. Accordingly, the first plate PT1 may support the display module 100 in the first area A1. In an embodiment, the first plate PT1 may have a substantially flat upper surface.

The second plate PT2 may extend from the first plate PT1 in the first direction D1. The first direction D1 may be a direction parallel to the first plate PT1. The second plate PT2 may be relatively flexible compared to the first plate PT1. The second plate PT2 may be exposed to the outside or accommodated inside as the display device 10 slides. In an embodiment, a plurality of openings OP spaced apart from each other in the first direction D1 at regular intervals may be disposed in the second plate PT2.

The flat bar FB may be disposed under the first plate PT1. For example, the flat bar FB may directly contact the first plate PT1. The flat bar FB may overlap the first area A1. The rigidity of the flat bar FB may be greater than the rigidity of the first plate PT1. Accordingly, the flat bar FB may support the first plate PT1 and the display module 100 in the first area A1. For example, the flat bar FB may include metal.

The flat bar FB may have a shape of a flat rectangular parallelepiped with a hollow inside. However, the shape of the flat bar FB is not necessarily limited thereto, and the flat bar FB may have various shapes. In an embodiment, the flat bar FB may be omitted. Here, the flat bar FB may be referred to as a flat support.

The plurality of segments SM may be disposed under the second plate PT2. The segments SM may overlap the second area A2. The segments SM may be spaced apart from each other in the first direction D1. Each of the segments SM may extend in the second direction D2 perpendicular to the first direction D1.

Each of the segments SM may directly contact the second plate PT2. In addition, the segments SM might not overlap the plurality of openings OP. The segments SM may allow a portion of the display module 100 overlapping the second area A2 to move while maintaining a smooth shape that is not deformed convexly. A detailed description of each of the segments SM will be described later.

A thickness of the flat bar FB may be the same as a thickness of each of the segments SM. Alternatively, the thickness of the flat bar FB may be different from the thickness of each of the segments SM. For example, the thickness of the flat bar FB may be smaller than the thickness of each of the segments SM.

The window protective layer WPL, the window member WD, the display panel PNL, the panel protective layer PPL, the support plate PT, the flat bar FB, and the segments SM may be attached to each other through an adhesive layer. However, the configuration of the present invention is not necessarily limited thereto, and the adhesive layer may be omitted.

FIG. 3 is a cross-sectional view taken along line II-II' of FIG. 1. FIG. 4 is a cross-sectional view illustrating the display device of FIG. 3 in an unfolded state. For example, FIGS. 3 and 4 are cross-sectional views illustrating a sliding method of the display device 10 of FIG. 1.

Referring to FIGS. 3 and 4, the display device 10, according to an embodiment, may further include a roller RL.

The roller RL may be disposed at one end of the display device 10. The roller RL may rotate clockwise or counterclockwise. When the roller RL rotates clockwise or counterclockwise, the display device 10 may be rolled or unfolded.

In an area adjacent to the roller RL, a portion of the display device 10 may be curved with a certain degree of curvature. For example, in an area adjacent to the roller RL, a portion of the display module 100 may be curved with a certain degree of curvature. In this case, the portion of the second plate PT2 overlapping the portion of the display module 100 may be curved with a certain degree of curvature.

When the roller RL rotates counterclockwise, the display device 10 may slide in an unfolding direction (e.g., the first direction D1) (see FIG. 3). When the display device 10 slides in the unfolding direction, the second area A2 may be unfolded from the roller RL. As the second area A2 is unfolded from the roller RL, the display area of the display device 10 that is visually recognized (e.g., in view) may be expanded (see FIG. 4).

When the roller RL rotates clockwise, the display device 10 may slide in a rolling direction (e.g., a direction opposite to the first direction D1) (see FIG. 4). When the display device 10 slides in the rolling direction, the second area A2 may be internally rolled from the roller RL. As the second area A2 is internally rolled from the roller RL, the display area of the display device 10 that is visually recognized (e.g., in view) may be reduced (see FIG. 3).

Accordingly, the display area of the display device 10 that is externally visible according to a sliding state of the display device 10 may be secured, and portability of the display device 10 may be increased.

As described above, a plurality of openings OP spaced apart from each other in the first direction D1 at regular intervals may be disposed in the second plate PT2 (see FIG. 2). Alternatively, the plurality of openings OP might not be disposed in the second plate PT2, and the second plate PT2 may continuously extend along the first direction D1.

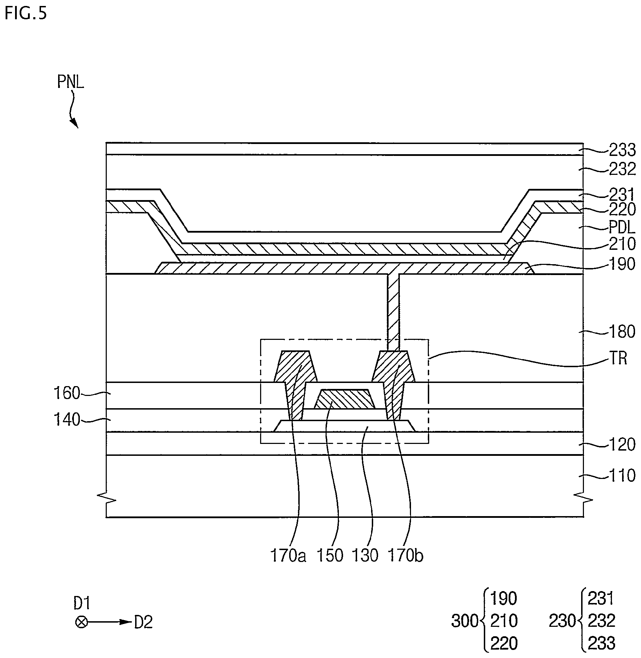

FIG. 5 is an enlarged cross-sectional view of a portion of the display panel of FIG. 2.

Referring to FIG. 5, the display panel PNL of the display device 10, according to an embodiment of the present invention, may include a substrate 110, a buffer layer 120, a gate insulating layer 140, an interlayer insulating layer 160, a transistor TR, a planarization layer 180, a pixel defining layer PDL, a light emitting element 300, and an encapsulation layer 230.

Here, the transistor TR may include an active layer 130, a gate electrode 150, a source electrode 170a, and a drain electrode 170b. The light emitting element 300 may include a lower electrode 190, a light emitting layer 210 and an upper electrode 220. In addition, the encapsulation layer 230 may include a first inorganic encapsulation layer 231, an organic encapsulation layer 232, and a second inorganic encapsulation layer 233.

The substrate 110 may include a transparent material or an opaque material. The substrate 110 may include a flexible transparent resin substrate. An example of a transparent resin substrate that can be used as the substrate 110 may be a polyimide substrate. Alternatively, the substrate 110 may include a quartz substrate, a synthetic quartz substrate, a calcium fluoride substrate, a soda lime glass substrate, an alkali-free glass substrate, and/or the like. These may be used alone or in combination with each other.

The buffer layer 120 may be disposed on the substrate 110. The buffer layer 120 may prevent diffusion of metal atoms or impurities from the substrate 110 into the transistor TR. For example, the buffer layer 120 may include an inorganic material such as oxide or nitride.

The active layer 130 may be disposed on the buffer layer 120. The active layer 130 may include a metal oxide semiconductor, an inorganic semiconductor (e.g., amorphous silicon, poly silicon, or an organic semiconductor). The active layer 130 may include a source region, a drain region, and a channel region disposed between the source region and the drain region.

The metal oxide semiconductor may include a two-component compound (ABx), a ternary compound (ABxCy), a four-component compound (ABxCyDz), and/or the like containing indium (In), zinc (Zn), gallium (Ga), tin (Sn), titanium (Ti), aluminum (Al), hafnium (Hf), zirconium (Zr), magnesium (Mg), and/or the like. For example, the metal oxide semiconductor may include zinc oxide (ZnOx), gallium oxide (GaOx), tin oxide (SnOx), indium oxide (InOx), indium gallium oxide (IGO), indium zinc oxide (IZO), indium tin oxide. (ITO), indium zinc tin oxide (IZTO), indium gallium zinc oxide (IGZO), and/or the like. These may be used alone or in combination with each other.

The gate insulating layer 140 may be disposed on the buffer layer 120. The gate insulating layer 140 may at least partially cover the active layer 130 on the substrate 110 and may have a substantially flat upper surface without creating a step around the active layer 130. Alternatively, the gate insulating layer 140 may cover the active layer 130 on the substrate 110 and may be disposed along the profile of the active layer 130 with a uniform thickness.

For example, the gate insulating layer 140 may include an inorganic material such as silicon oxide (SiOx), silicon nitride (SiNx), silicon carbide (SiCx), silicon oxynitride (SiOxNy), silicon oxycarbide (SiOxCy), and/or the like. These may be used alone or in combination with each other.

The gate electrode 150 may be disposed on the gate insulating layer 140. The gate electrode 150 may overlap the channel region of the active layer 130. For example, the gate electrode 150 may include a metal, an alloy, a metal nitride, a conductive metal oxide, a transparent conductive material, and/or the like. These may be used alone or in combination with each other.

The interlayer insulating layer 160 may be disposed on the gate insulating layer 140. The interlayer insulating layer 160 may at least partially cover the gate electrode 150 on the substrate 110 and may have a substantially flat upper surface without creating a step around the gate electrode 150. Alternatively, the interlayer insulating layer 160 may cover the gate electrode 150 on the substrate 110 and may be disposed along the profile of the gate electrode 150 with a uniform thickness.

For example, the interlayer insulating layer 160 may include an inorganic material such as silicon oxide, silicon nitride, silicon carbide, silicon oxynitride, silicon oxycarbide, and/or the like. These may be used alone or in combination with each other.

The source electrode 170a and the drain electrode 170b may be disposed on the interlayer insulating layer 160. The source electrode 170a may be connected to the source region of the active layer 130 through a contact hole formed by removing a first portion of the gate insulating layer 140 and the interlayer insulating layer 160, The drain electrode 170b may be connected to the drain region of the active layer 130 through a contact hole formed by removing a second portion of the gate insulating layer 140 and the interlayer insulating layer 160. For example, each of the source electrode 170a and the drain electrode 170b may include a metal, an alloy, a metal nitride, a conductive metal oxide, a transparent conductive material, and/or the like. These may be used alone or in combination with each other.

Accordingly, the transistor TR including the active layer 130, the gate electrode 150, the source electrode 170a, and the drain electrode 170b may be disposed on the substrate 110.

The planarization layer 180 may be disposed on the interlayer insulating layer 160. The planarization layer 180 may at least partially cover the source electrode 170a and the drain electrode 170b. The planarization layer 180 may include an organic material or an inorganic material. For example, the planarization layer 180 may include an organic material such as polyimide-based resin, photoresist, polyacryl-based resin, polyamide-based resin, a siloxane-based resin, and/or the like. These may be used alone or in combination with each other.

The lower electrode 190 may be disposed on the planarization layer 180. The lower electrode 190 may be connected to the drain electrode 170b through a contact hole formed by removing a portion of the planarization layer 180. For example, the lower electrode 190 may include a metal, an alloy, a metal nitride, a conductive metal oxide, a transparent conductive material, and/or the like. These may be used alone or in combination with each other.

The pixel defining layer PDL may be disposed on the planarization layer 180. The pixel defining layer PDL may include an opening exposing a portion of the lower electrode 190. The pixel defining layer PDL may include an organic material or an inorganic material. For example, the pixel defining layer PDL may include an organic material such as polyimide.

The light emitting layer 210 may be disposed on the lower electrode 190. For example, the light emitting layer 210 may be disposed within the opening of the lower electrode 190. The light emitting layer 210 may be formed using at least one of light emitting materials that emit different color lights (e.g., red light, green light, blue light, and/or the like) according to sub-pixels. Alternatively, the light emitting layer 210 may emit white light as a whole by stacking a plurality of light emitting materials capable of generating different color lights such as red light, green light, and blue light.

The upper electrode 220 may be disposed on the pixel defining layer PDL and the light emitting layer 210. For example, the upper electrode 220 may include a metal, an alloy, a metal nitride, a conductive metal oxide, a transparent conductive material, and/or the like. These may be used alone or in combination with each other.

Accordingly, the light emitting element 300 including the lower electrode 190, the light emitting layer 210, and the upper electrode 220 may be disposed on the substrate 110.

The first inorganic encapsulation layer 231 may be disposed on the upper electrode 220. The first inorganic encapsulation layer 231 may prevent the light emitting layer 210 from being deteriorated due to penetration of moisture, oxygen, and/or the like. In addition, the first inorganic encapsulation layer 231 may also perform a function of protecting the display panel PNL from external impact. The first inorganic encapsulation layer 231 may include inorganic materials having flexibility.

The organic encapsulation layer 232 may be disposed on the first inorganic encapsulation layer 231. The organic encapsulation layer 232 may increase flatness of the display panel PN and may protect the display panel PNL. The organic encapsulation layer 232 may include flexible organic materials.

The second inorganic encapsulation layer 233 may be disposed on the organic encapsulation layer 232. The second inorganic encapsulation layer 233, together with the first inorganic encapsulation layer 231, may prevent the light emitting layer 210 from deteriorating due to penetration of moisture, oxygen, and/or the like. In addition, the second inorganic encapsulation layer 233 may also perform a function of protecting the display panel PNL together with the first inorganic encapsulation layer 231 and the organic encapsulation layer 232 from external impact. The second inorganic encapsulation layer 233 may include inorganic materials having flexibility.

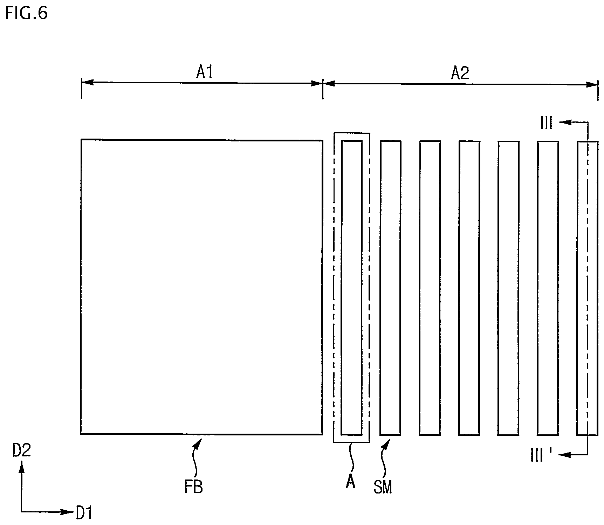

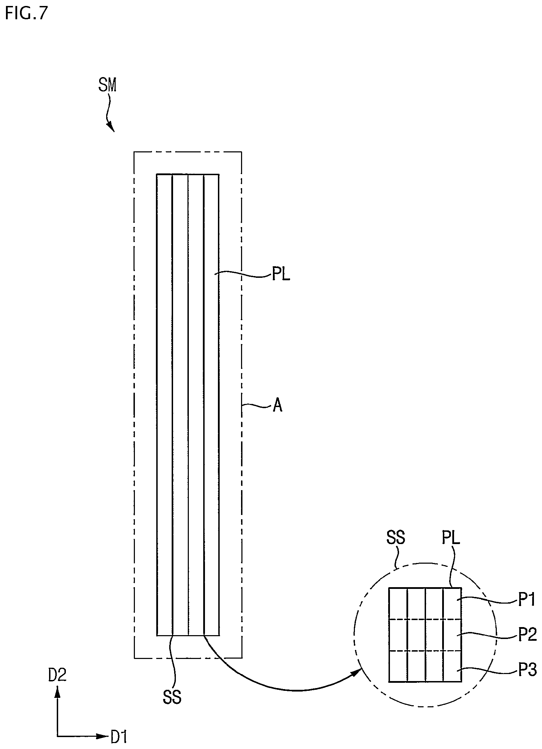

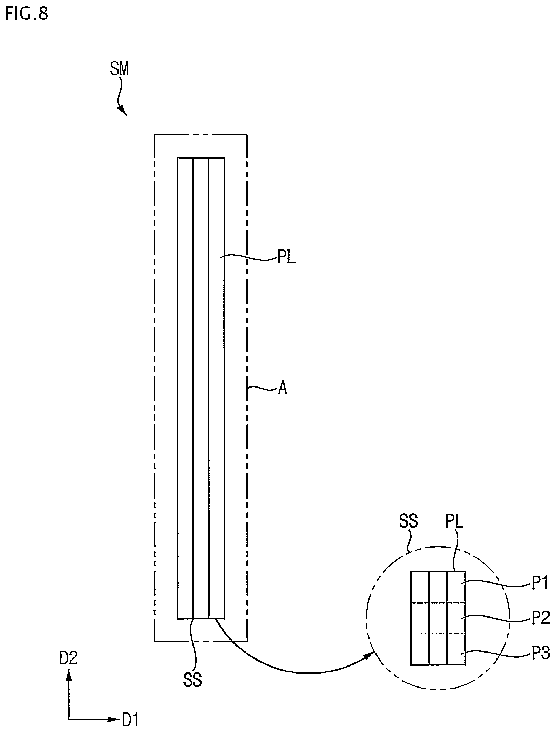

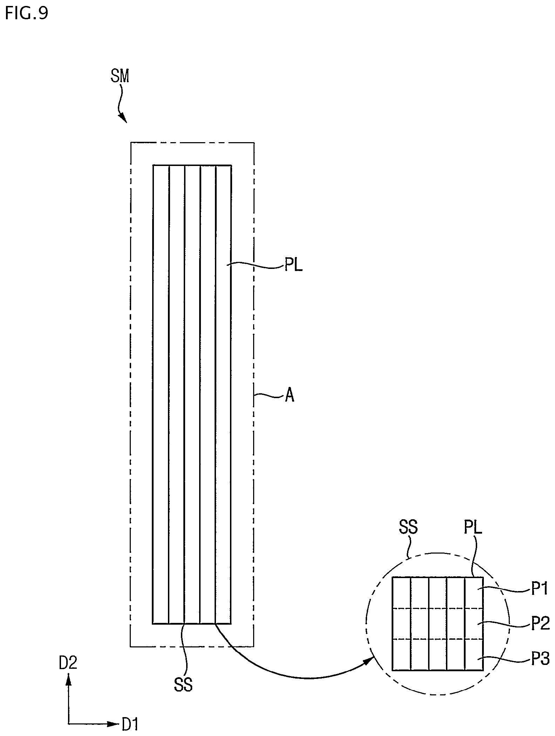

FIG. 6 is a plan view illustrating a flat bar and the segments of FIG. 2. FIG. 7 is an enlarged plan view of an example of area A of FIG. 6. FIGS. 8 and 9 are enlarged plan views of other examples of area A of FIG. 6.

Referring to FIGS. 6, 7, 8, and 9, as described above, the flat bar FB may be disposed in the first area A1 and the segments SM may be disposed in the second area A2.

In an embodiment, each of the segments SM may have a structure in which a plurality of plates PL are laminated. For example, the plates PL may have the same shape as each other. As each of the segments SM has a structure in which the plates PL are laminated, the rigidity of each of the segments SM in the second direction D2 (i.e., a direction in which the segmental member SM extends) may be increased. In this case, the rigidity of each of the segments SM in the first direction D1 (i.e., a direction in which the segments SM are spaced apart) may decrease.

For example, each of the segments SM may have a structure in which four plates PL are laminated (see FIG. 7). Alternatively, each of the segments SM may have a structure in which three plates PL are laminated (see FIG. 8). Alternatively, each of the segments SM may have a structure in which five plates PL are laminated (see FIG. 9). However, the configuration of the present invention is not necessarily limited thereto, and each of the segments SM may have a structure in which six or more plates PL are laminated.

Each of the plates PL of each of the segments SM may include metal, glass, plastic, or the like. For example, each of the plates PL of each of the segments SM may include magnesium (Mg), stainless steel (SUS), and/or the like. Alternatively, each of the plates PL of each of the segments SM may include glass fiber reinforced plastic (GFRP), carbon fiber reinforced plastic (CFRP), and/or the like. These may be used alone or in combination with each other.

In an embodiment, at least two of the plates PL of each of the segments SM may include materials different from each other. Accordingly, weight reduction of the segments SM may be realized. In an embodiment, the plates PL of each of the segments SM may include the same material as each other.

For example, when each of the segments SM has a structure in which the four plates PL are laminated, each of the segments SM may have a structure including SUS/Mg/Mg/SUS or a structure including CFRP/SUS/CFRP/SUS. However, the configuration of the present invention is not necessarily limited thereto, and each of the segments SM may have a structure including various metals, plastics, or the like.

Each of the segments SM may be manufactured by processing a preliminary plate having a specific thickness. For example, the plurality of plates PL may be formed by cutting the preliminary plate through etching, laser, or the like, and then the plurality of plates PL may be laminated through bonding, welding, laser, or the like. Alternatively, after forming the plurality of plates PL by processing the preliminary plate through a press process or the like, the plurality of plates PL may be laminated through bonding, welding, laser, or the like. Accordingly, the segments SM having a structure in which the plurality of plates PL are laminated may be manufactured.

When a side surface SS of each of the segments SM is enlarged and viewed, each of the plates PL of each of the segments SM may be divided into a first portion P1, a third portion P3, and a second portion P2 between the first portion P1 and the third portion P3. As each of the plates PL is divided into the first portion P1, the second portion P2, and the third portion P3, each of the segments SM may be divided into the first portion P1, the second portion P2, and the third portion P3.

Here, the side surface SS of the segments SM may refer to the side surface SS when the segments SM is viewed in the second direction D2. A detailed description of the first, second, and third portions P1, P2, and P3 will be described later.

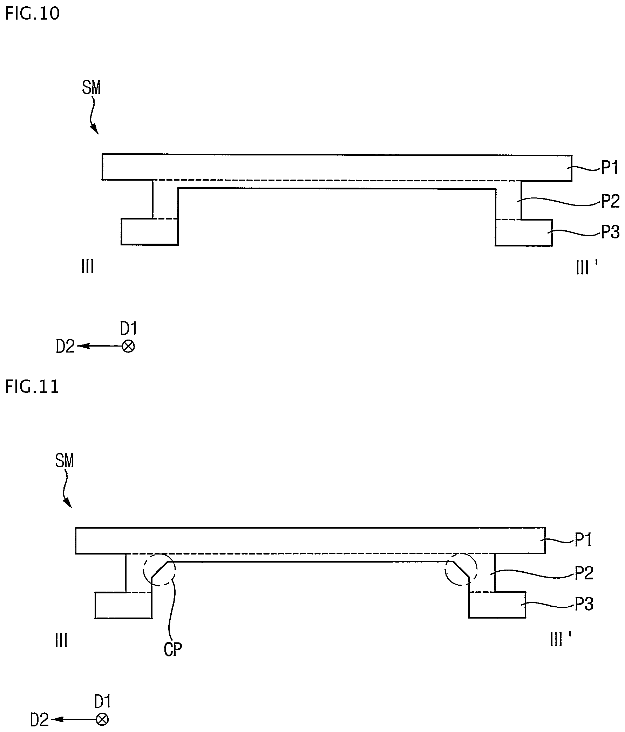

FIG. 10 is a cross-sectional view illustrating an example of a cross-section of the segments of FIGS. 6 and 7 taken along line III-III'.

Referring to FIG. 10, the segments SM may include the first portion P1, the second portion P2, and two third portions P3.

The first portion P1 may face a display module (e.g., the display module 100 of FIG. 2). For example, the first portion P1 may be a portion that directly contacts the support plate (e.g., the support plate PT of FIG. 2).

The second portion P2 may contact the first portion P1. For example, an upper surface of the second portion P2 may contact a lower surface of the first portion P1. In an embodiment, the second portion P2 may have a rectangular cross-sectional shape with one side open. For example, the second portion P2 may have a "C" cross-sectional shape or the shape of a rectangular bracket "[".

Each of the third portions P3 may contact both ends of the second portion P2. In an embodiment, both ends of the first portion P1 may protrude to a greater extent than the ends of each of the third portions P3.

The display device 10, according to an embodiment of the present invention, may include the display module 100 including the first area A1 and the second area A2 adjacent to the first area A1 and a plurality of segments SM disposed under the display module 100, overlapping the second area A2, and each having a structure in which a plurality of plates PL are laminated. At least a portion of the second area A2 may be curved with a constant curvature. Accordingly, rigidity of each of the segments SM in a specific direction (e.g., a direction in which the segments SM extend) may be increased.

In addition, at least two of the plurality of plates PL may include materials different from each other. Accordingly, weight reduction of the segments SM may be realized.

FIGS. 11, 12, 13, and 14 are cross-sectional views illustrating other examples of a cross-section of the segments of FIGS. 6 and 7 taken along line III-III'.

In the following, in the segments SM described with reference to FIGS. 11, 12, 13, and 14, to the extent that an element is not described in detail, it may be understood that the element is at least similar to corresponding elements that have been described above with respect to FIG. 10.

Referring to FIGS. 11, 12, 13, and 14, the segments SM may include the first portion P1, the second portion P2, and the two third portions P3.

First, referring to FIG. 11, in an embodiment, at least one corner portion CP disposed inside the second portion P2 of the segments SM may have a cross-sectional shape including a straight line extending in an oblique direction. In an embodiment, the at least one corner portion CP disposed inside the second portion P2 of the segments SM may have a cross-sectional shape including a curve extending in the oblique direction. Accordingly, internal rigidity of the segments SM may be increased.

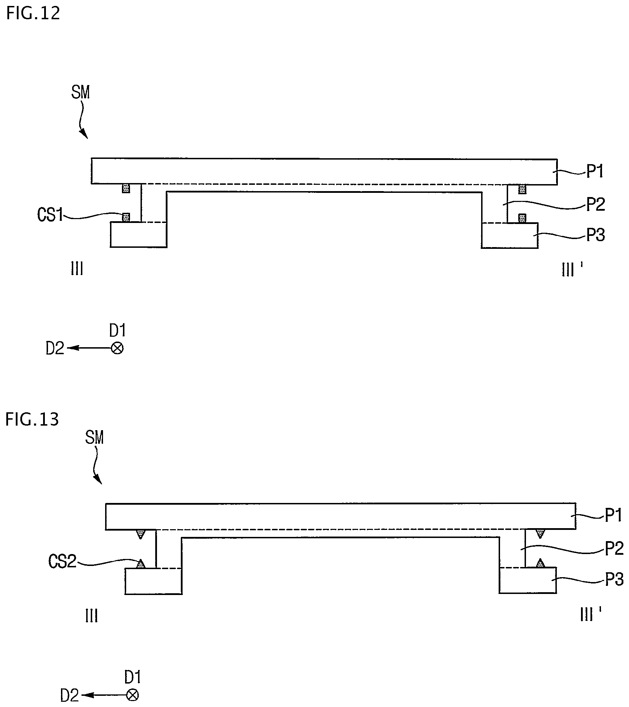

Referring to FIGS. 12 and 13, in an embodiment, the segments SM may include a contact structure CS1 and CS2 coupled to both ends of the first portion P1 and each of the third portions P3 of the segments SM. The contact structure CS1 and CS2 coupled to the first portion P1 of the segments SM and the contact structure CS1 and CS2 coupled to the third portion P3 of the segments SM may face each other. When a display device (e.g., the display device 10 of FIGS. 1, 2, 3, and 4) slides as the contact structure CS1 and CS2 are coupled to both ends of the first portion P1 and each of the third portion s P3 of the segments SM, a rail and the contact structure CS1 and CS2 may make line contact. In this case, frictional force between the rail and the segments SM may be reduced.

For example, the contact structure CS1 and CS2 may be formed independently of the first, second, and third portions P1, P2 and P3 of the segments SM. Alternatively, the contact structure CS1 and CS2 may be integrally formed with the first, second, and third portions P1, P2 and P3 of the segments SM.

For example, as shown in FIG. 12, the contact structure CS1 may have a quadrilateral cross-sectional shape. Alternatively, as shown in FIG. 13, the contact structure CS2 may have a triangular cross-sectional shape. However, the configuration of the present invention is not necessarily limited thereto, and the contact structures CS1 and CS2 may have various polygonal cross-sectional shapes.

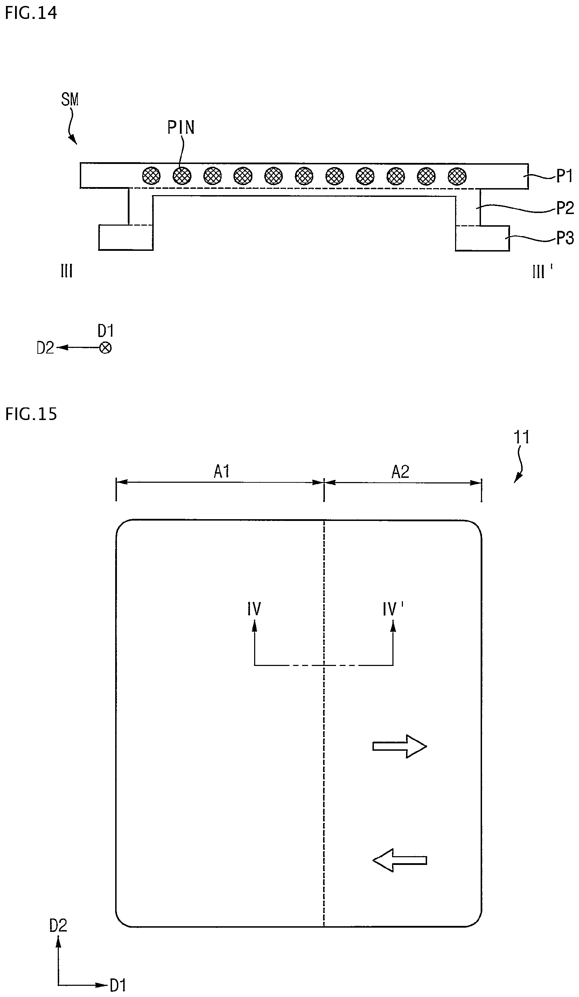

Referring to FIG. 14, in an embodiment, the segments SM may include a plurality of pins PIN inserted into the first portion P1 of the segments SM. The pins PIN may be spaced apart from each other in the second direction D2. For example, a plurality of holes may be formed in the first portion P1 of the segments SM, and the pins PIN may be inserted into the holes. Accordingly, the rigidity of the segments SM may be increased. For example, the rigidity of the segments SM in the second direction D2 may be increased.

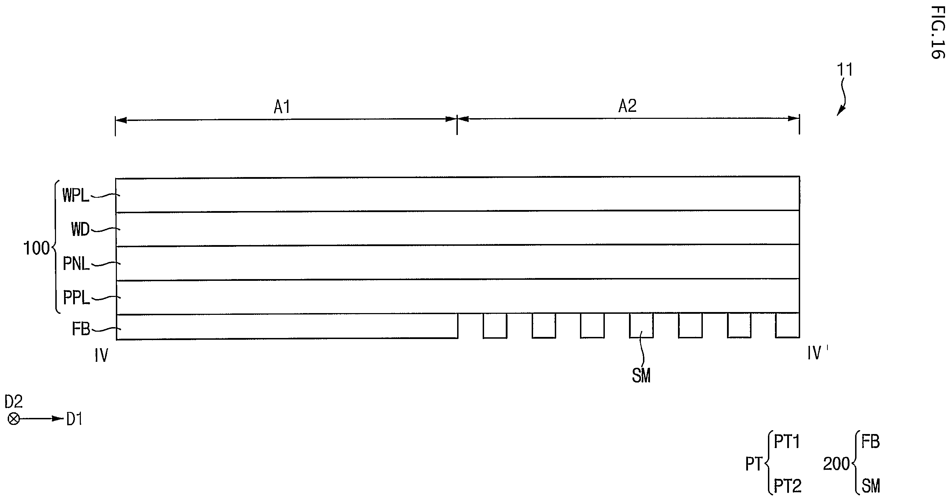

FIG. 15 is a plan view illustrating a display device according to an embodiment of the present invention. FIG. 16 is a cross-sectional view taken along line IV-IV' of FIG. 15.

Hereinafter, in a display device 11 described with reference to FIGS. 15 and 16, to the extent that an element is not described in detail, it may be understood that the element is at least similar to corresponding elements that have been described above with respect to FIGS. 1 and 2.

Referring to FIG. 15, the display device 11, according to an embodiment of the present invention, may include a first area A1 and a second area A2. The second area A2 may be disposed adjacent to the first area A1. For example, the second area A2 may be disposed adjacent to the first area A1 in the first direction D1.

Each of the first area A1 and the second area A2 may be a display area for displaying an image. However, the configuration of the present invention is not necessarily limited thereto, and each of the first area A1 and the second area A2 may partially display an image.

Referring to FIG. 16, the display device 11, according to an embodiment of the present invention, may include a display module 100 and a lower structure 200. Here, the display module 100 may include a panel protection layer PPL, a display panel PNL, a window member WD, and a window protection layer WPL.

The lower structure 200 may include a flat bar FB and a plurality of segments SM. For example, the lower structure 200 might not include a support plate (e.g., the support plate PT of FIG. 2). Accordingly, the manufacturing cost of the display device DD may be reduced.

The flat bar FB may be disposed under the display module 100. For example, the flat bar FB may be disposed under the panel protection layer PPL. The flat bar FB may overlap the first area A1. As the display device 11 does not include the support plate, the flat bar FB may directly contact the panel protection layer PPL.

The segments SM may be disposed under the display module 100. For example, the segments SM may be disposed under the panel protection layer PPL. The segments SM may overlap the second area A2. As the display device 11 does not include the support plate, the segments SM may directly contact the panel protection layer PPL.

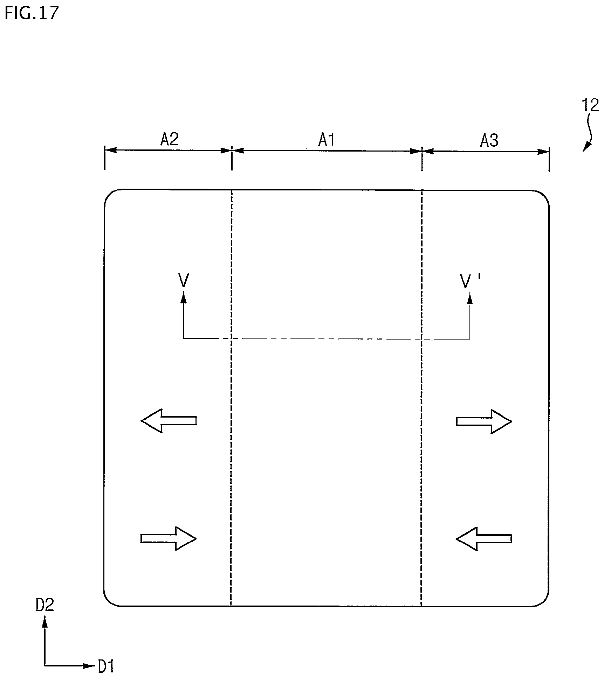

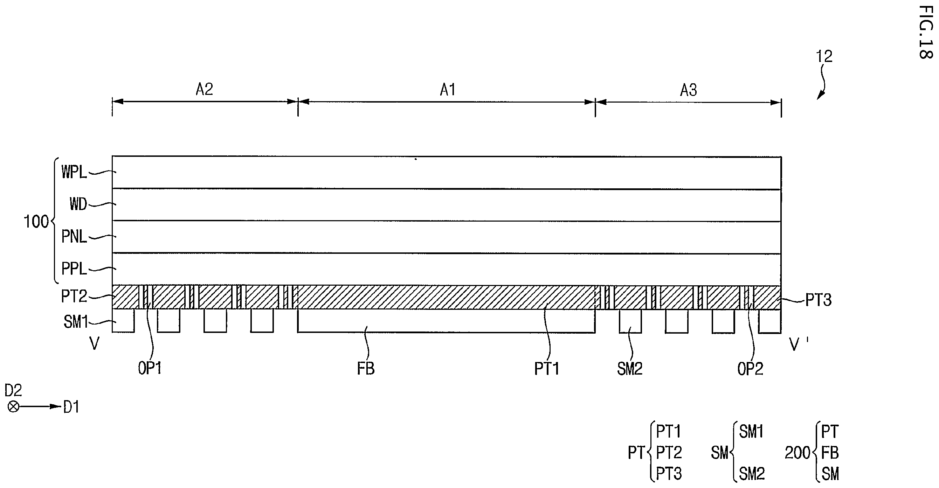

FIG. 17 is a plan view illustrating a display device according to an embodiment of the present invention. FIG. 18 is a cross-sectional view taken along line V-V' of FIG. 15.

Hereinafter, in a display device 12 described with reference to FIGS. 17 and 18, to the extent that an element is not described in detail, it may be understood that the element is at least similar to corresponding elements that have been described above with respect to FIGS. 1 and 2.

Referring to FIG. 17, the display device 12, according to an embodiment of the present invention, may include a first area A1, a second area A2, and a third area A3. The second area A2 may be disposed adjacent to the first area A1, and the third area A3 may be disposed adjacent to the first area A1. For example, the first area A1 may be disposed between the second area A2 and the third area A3.

Each of the first area A1, the second area A2, and the third area A3 may be a display area capable of displaying an image. However, the present invention is not necessarily limited thereto, and each of the first area A1, the second area A2, and the third area A3 may partially display an image.

The first area A1 may be an area exposed to the outside and may have a flat shape. Each of the second area A2 and the third area A3 may be flexible, and may be exposed to the outside or accommodated as the display device 10 slides. Each of the second area A2 and the third area A3 may have a flat shape when exposed to the outside, and may have a curved shape when accommodated inside.

The second area A2 may be disposed adjacent to a first side of the first area A1, and the third area A3 may be disposed adjacent to a second side of the first area A1. The second side may face the first side. However, the configuration of the present invention is not necessarily limited thereto.

When the display device 12 is slid, the area of each of the second area A2 and the third area A3 may change. When the display device 12 is slid and unfolded, the area of each of the second area A2 and the third area A3 may increase. When the display device 12 is slid and rolled, the area of each of the second area A2 and the third area A3 may decrease. Areas of the second area A2 and the third area A3 may vary independently of each other. For example, when the area of the second area A2 increases or decreases, the area of the third area A3 may be constant. Unlike this, when the area of the third area A3 increases or decreases, the area of the second area A2 may be constant.

Referring to FIG. 18, the display device 12, according to an embodiment of the present invention, may include a display module 100 and a lower structure 200. The display module 100 may include a panel protection layer PPL, a display panel PNL, a window member WD, a window protection layer WPL, and the lower structure 200 may include a support plate PT, a flat bar FB, and a plurality of segments SM.

The display module 100 may include a first portion, a second portion, and a third portion. The first portion may overlap the first area A1. The first portion may be a portion exposed to the outside and may have a flat shape.

The second portion may overlap the second area A2, and the third portion may overlap the third area A3. Each of the second portion and the third portion may be flexible. The second portion may extend from the first portion in a direction opposite to the first direction D1, and the third portion may extend from the first portion in the first direction D1. Each of the second and third portions may be exposed to the outside or accommodated inside as the display device 12 slides. Each of the second portion and the third portion may have a flat shape when exposed to the outside, and may have a curved shape when accommodated inside.

The support plate PT may be disposed under the display module 100. In an embodiment, the support plate PT may include a first plate PT1, a second plate PT2, and a third plate PT3. The first plate PT1 may overlap the first area A1, the second plate PT2 may overlap the second area A2, and the third plate PT3 may overlap the third area A3.

The second plate PT2 may extend from the first plate PT1 in a direction opposite to the first direction D1, and the third plate PT3 may extend from the first plate PT1 in the first direction D1. Each of the second plate PT2 and the third plate PT3 may be more flexible than the first plate PT1. In an embodiment, a plurality of first openings OP1 spaced apart from each other in the first direction D1 at regular intervals may be disposed in the second plate PT2, and a plurality of second openings OP2 spaced apart from each other in the first direction D1 at regular intervals may be disposed in the third plate PT3.

Each of the second plate PT2 and the third plate PT3 may be exposed to the outside or accommodated inside as the display device 12 slides.

The flat bar FB may be disposed under the first plate PT1. For example, the flat bar FB may directly contact the first plate PT1. The flat bar FB may overlap the first area A1. The flat bar FB may have a flat rectangular parallelepiped shape with a hollow inside. However, the shape of the flat bar FB is not necessarily limited thereto, and the flat bar FB may have various shapes. In an embodiment, the flat bar FB may be omitted.

The segments SM may include first segments SM1 and second segments SM2. The first segments SM1 may be disposed under the second plate PT2, and the second segments SM2 may be disposed under the third plate PT3. For example, the first segments SM1 may overlap the second area A2, and the second segments SM2 may overlap the third area A3.

The first segments SM1 may be spaced apart from each other in the first direction D1, and the second segments SM2 may be spaced apart from each other in the first direction D1. Each of the first segments SM1 may directly contact the second plate PT2, and each of the second segments SM2 may directly contact the third plate PT3. In addition, the first segments SM1 might not overlap the first openings OP1, and the second segments SM2 might not overlap the second openings OP2.

The segments SM may allow the second portion of the display module 100 overlapping the second area A2 and the third portion of the display module 100 overlapping the third area A3 to move while maintaining a smooth shape that is not convexly deformed.

A structure of each of the first segments SM1 and the second segments SM2 may be substantially the same as the structure of the segments SM described with reference to FIGS. 6, 7, 8, 9, 10, 11, 12, 13, and 14.

Although the embodiments of the present invention have been described above, it will be understood by those of ordinary skill in the art that various changes and modifications can be made to the present invention without departing from the idea and scope of the present invention as set forth in the appended claims.

### [Industrial Applicability]

The present invention can be applied to various display devices. For example, the present disclosure is applicable to various display devices such as display devices for vehicles, ships and aircraft, portable communication devices, display devices for exhibition or information transmission, medical display devices, and/or the like.

### <Explanation of Reference Number>

| | | | |
|---|---|---|---|
| 10, 11, 13: | display device | A1: | first area |
| A2: | second area | 100: | display module |
| 200: | lower structure | PT: | support plate |
| PT1: | first plate | PT2: | second plate |
| OP: | openings | FB: | flat bar |
| SM: | segments | PL: | plates |
| P1, P2, P3: | first, second, and third portions | | |

## Claims

1. A display device, comprising:
a display module including a first area and a second area adjacent to the first area, wherein at least a portion of the second area is curved;
a flat support disposed under the display module and overlapping the first area; and
a plurality of segments disposed under the display module, overlapping the second area, and each having a structure including a plurality of laminated plates.

2. The display device of claim 1, wherein at least two of the plates include materials different from each other.

3. The display device of claim 1, wherein the plates include a same material as each other.

4. The display device of claim 1, wherein each of the plates includes stainless steel (SUS), fiber reinforced plastic (FRP), and/or magnesium (Mg).

5. The display device of claim 1, wherein the plates have a same shape as each other.

6. The display device of claim 1, wherein each of the plates includes:
a first portion facing the display module;
a second portion contacting the first portion and having a rectangular cross-sectional shape with one side open; and
two third portions respectively contacting both ends of the second portion.

7. The display device of claim 6, wherein both ends of the first portion protrude to a greater extent than both ends of each of the third portions.

8. The display device of claim 6, wherein at least one corner portion disposed inside the second portion has a cross-sectional shape including a straight line or a curved line extending in an oblique direction.

9. The display device of claim 6, wherein each of the segments includes a contact structure coupled to both ends of the first portion and to each of the third portions.

10. The display device of claim 9, wherein the contact structure is integrally formed with the segments.

11. The display device of claim 9, wherein the contact structure has a polygonal cross-sectional shape.

12. The display device of claim 11, wherein the contact structure has a quadrilateral cross-sectional shape or a triangular cross-sectional shape.

13. The display device of claim 6, wherein each of the segments includes a plurality of pins inserted into the first portion and spaced apart from each other at regular intervals.

14. The display device of claim 1, further comprising:
a support plate disposed under the display module and including a first plate and overlapping the first area and a second plate overlapping the second area and extending from the first plate.

15. The display device of claim 14, wherein a plurality of openings spaced apart from each other at regular intervals are disposed in the second plate.

16. The display device of claim 15, wherein each of the segments directly contacts the second plate and does not overlap the openings.

17. A display device, comprising:
a display module including a first area and a second area adjacent to the first area, wherein at least a portion of the second area is curved; and
a plurality of segments disposed under the display module, overlapping the second area, spaced apart from each other in a first direction, each extending in a second direction crossing the first direction, and each having a structure including a plurality of laminated plates.

18. The display device of claim 17, wherein at least two of the plates include materials different from each other.

19. The display device of claim 17, wherein the plates include a same material as each other.

20. The display device of claim 17, wherein each of the plates includes stainless steel, fiber reinforced plastic, and/or magnesium.

21. The display device of claim 17, wherein each of the plates includes:
a first portion facing the display module;
a second portion contacting the first portion and having a rectangular cross-sectional shape with one side open; and
two third portions respectively contacting both ends of the second portion.

22. The display device of claim 21, wherein both ends of the first portion protrude to a greater extent than both ends of each of the third portions.

23. The display device of claim 21, wherein at least one corner portion disposed inside the second portion has a cross-sectional shape including a straight line or a curved line extending in an oblique direction.

24. The display device of claim 21, wherein each of the segments includes a contact structure coupled to both ends of the first portion and to each of the third portions.

25. The display device of claim 24, wherein the contact structure is integrally formed with the segments.

26. The display device of claim 24, wherein the contact structure has a quadrilateral cross-sectional shape or a triangular cross-sectional shape.

27. The display device of claim 21, wherein each of the segments includes a plurality of pins inserted into the first portion and spaced apart from each other at regular intervals.
